# EUROPEAN PATENT APPLICATION

(11) **EP 4 270 455 A1**
(43) Date of publication of application: **01.11.2023**
(21) Application number: 22170303.6
(22) Date of filing: 27.04.2022
(51) Int. Cl.: H01L 21/60, H01L 21/56, H01L 23/48, H01L 23/31, H01L 23/29, B29C 45/14, B29C 33/42

(54) **SEMICONDUCTOR PACKAGE AND METHOD FOR FABRICATING THE SAME**

(71) Applicant: Infineon Technologies Austria AG, 9500 Villach (AT)
(72) Inventor: GRASSMANN, Andreas, 93049 Regensburg (DE); NIKITIN, Ivan, 93057 Regensburg (DE)
(74) Representative: Lambsdorff & Lange Patentanwälte Partnerschaft mbB

(57) **Abstract**

A semiconductor package comprises a substrate, a first (120) and a second (130) semiconductor die arranged on the substrate (110), a molded body (140) encapsulating the first (120) and second (130) semiconductor dies, the molded body (140) comprising a first external side facing away from the substrate (110), a plurality of electrical connectors (150) extending at least partially through the molded body (140) from the first external side to the first (120) and/or second (130) semiconductor die, and a plurality of plated conductive tracks (160) arranged in trenches (170) within the molded body (140) on the first external side, the conductive tracks (160) being coupled to the first (120) and/or second (130) semiconductor die by the electrical connectors (150). Also discloses a method of obtaining said semiconductor package.

## Description

### TECHNICAL FIELD

This disclosure relates in general to a semiconductor package, in particular to a semiconductor package, wherein a molded body comprises trenches with conductive tracks, as well as to a method for fabricating the same.

### BACKGROUND

The fabrication of semiconductor packages may comprise a plurality of different processes, for example mounting a semiconductor die to a substrate, encapsulating the die, fabricating electrical connections between the die and other parts of the package and singulating the package. The individual processes can be performed using different techniques and/or different types of components, each of which having their own advantages and disadvantages as well as their own costs. Conventional methods of fabricating a semiconductor package may comprise a combination of comparatively cheap processes with comparatively expensive processes. Apart from costs, some processes may also have other disadvantages which may limit the usefulness of the fabricated semiconductor package. Improved semiconductor packages as well as improved methods for fabricating semiconductor packages may help in solving these and other problems.

The problem on which the invention is based is solved by the features of the independent claims. Further advantageous examples are described in the dependent claims.

### SUMMARY

Various aspects pertain to a semiconductor package, comprising: a substrate, a first and a second semiconductor die arranged on the substrate, a molded body encapsulating the first and second semiconductor dies, the molded body comprising a first external side facing away from the substrate, a plurality of electrical connectors extending at least partially through the molded body from the first external side to the first and/or second semiconductor die, and a plurality of plated conductive tracks arranged in trenches within the molded body on the first external side, the conductive tracks being coupled to the first and/or second semiconductor die by the electrical connectors.

Various aspects pertain to a method for fabricating a semiconductor package, the method comprising: providing a substrate, providing a first and a second semiconductor die arranged on the substrate, providing a molded body encapsulating the first and second semiconductor dies, the molded body comprising a first external side facing away from the substrate, providing a plurality of electrical connectors extending at least partially through the molded body from the first external side to the first and/or second semiconductor die, and fabricating by plating a plurality of conductive tracks in trenches within the molded body on the first external side, the conductive tracks being coupled to the first and/or second semiconductor die by the electrical connectors.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figures 1A to 1C show a plan view (Fig. 1A) and two sectional views (Figs. 1B and 1C) of an exemplary semiconductor package comprising a molded body, wherein trenches in the molded body comprise conductive tracks.
Figure 2 shows a sectional view of a further exemplary semiconductor package, wherein the conductive tracks are at least partially covered by a dielectric layer.
Figure 3 shows a sectional view of a further exemplary semiconductor package, wherein opposite sides of a substrate are at least partially covered by the molded body.
Figures 4A to 4C show sectional views of a further semiconductor package in various stages of fabrication, according to an exemplary method for fabricating semiconductor packages.
Figure 5 shows a sectional view of a further exemplary semiconductor package comprising electrical connectors in the form of bond wire loops.
Figure 6 is a flow chart of an exemplary method for fabricating semiconductor packages.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. Furthermore, to the extent that the terms "include", "have", "with" or other variants thereof are used in either the detailed description or the claims, such terms are intended to be inclusive in a manner similar to the term "comprise". The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "attached", or "connected" elements. However, it is also possible that the "bonded", "attached", or "connected" elements are in direct contact with each other. Also, the term "exemplary" is merely meant as an example, rather than the best or optimal.

In several examples, layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole like, for example, laminating techniques as well as techniques in which layers are deposited in a sequential manner like, for example, sputtering, plating, molding, CVD, etc.

An efficient semiconductor package as well as an efficient method for fabricating a semiconductor package may for example reduce material consumption, ohmic losses, chemical waste, etc. and may thus enable energy and/or resource savings. Improved semiconductor packages as well as improved methods for fabricating a semiconductor package, as specified in this description, may thus at least indirectly contribute to green technology solutions, i.e. climate-friendly solutions providing a mitigation of energy and/or resource use.

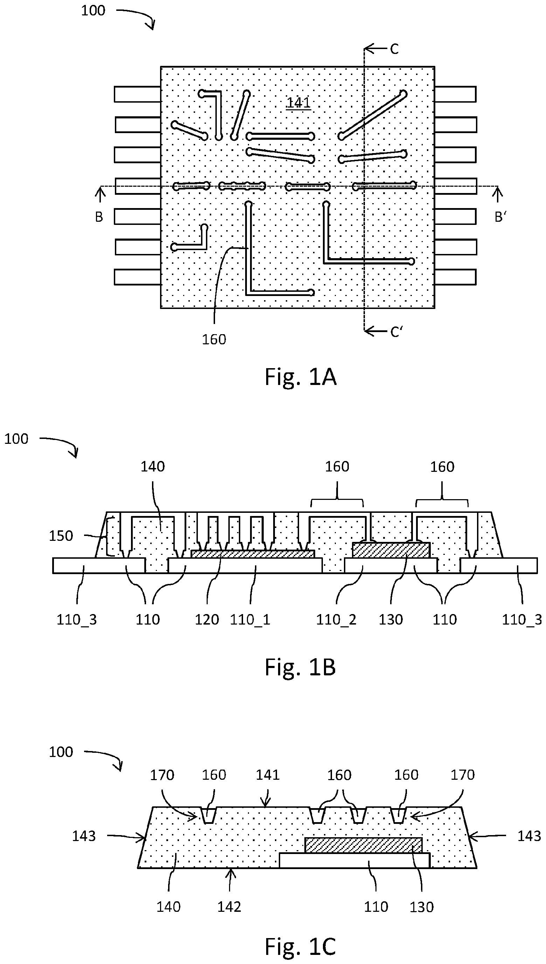

Figure 1A shows a plan view onto the upper side of a semiconductor package 100. Figure 1B shows a sectional view along the line B-B' in Fig. 1A and Figure 1C shows a sectional view along the line C-C' in Fig. 1A. The semiconductor package 100 comprises a substrate 110, a first semiconductor die 120, a second semiconductor die 130, a molded body 140, a plurality of electrical connectors 150 and a plurality of conductive tracks 160.

The semiconductor package 100 may be a power semiconductor package configured to operate with a high voltage and/or a high current. The semiconductor package 100 may comprise any suitable electrical circuit, for example a converter circuit, an inverter circuit, a half-bridge circuit, etc.

According to an example, the semiconductor package 100 is a surface mount device (SMD). According to another example, the semiconductor package 100 is a through hole device (THD). According to an example, the semiconductor package 100 comprises external contacts in the form of a ball grid array (BGA) .

The first and a second semiconductor dies 120, 130 are arranged on the substrate 110. The first and second semiconductor dies 120, 130 may in particular be arranged on the same side of the substrate 110.

The substrate 110 may for example comprise or consist of at least one substrate of the type leadframe, direct copper bond (DCB), direct aluminum bond (DAB), active metal braze (AMB) and printed circuit board (PCB). The semiconductor package 100 may comprise a single type of substrate (e.g. a leadframe) or the semiconductor package 100 may comprise different types of substrates (e.g. a leadframe and a PCB). The substrate 110 may for example comprise or consist of a metal or metal alloy like Ag, Al, Au or Cu. According to an example, the substrate 110 comprises a plating, for example a Ni plating or a NiAu plating. The plating may in particular cover exposed parts of the substrate 110.

The substrate 110 may for example comprise more than one part, wherein the parts of the substrate are separated from each other. The substrate 110 may for example comprise at least a first part 110_1 and a second part 110_2, wherein the first semiconductor die 120 is arranged on the first part 110_1 and the second semiconductor die 130 is arranged on the second part 110_2. The substrate 110 may further comprise a plurality of third parts 110_3, wherein the third parts 110_3 are external contacts of the semiconductor package 100.

The first and second semiconductor dies 120, 130 may be any suitable types of semiconductor dies. For example, at least one of the first and second semiconductor dies 120, 130 may be a power semiconductor die, in particular a power transistor die. According to an example, at least one of the first and second semiconductor dies 120, 130 may be a logic die configured to control one or more power semiconductor dies.

The first and second semiconductor dies 120, 130 may be identical dies or, as shown in Fig. 1B, the first and second semiconductor dies 120, 130 may be different types of dies. The semiconductor package 100 may comprise more than one first semiconductor dies 120 and/or more than one second semiconductor dies 130.

The first and second semiconductor dies 120, 130 may for example be attached to the substrate 110 by soldering, sintering or gluing. The first and second semiconductor dies 120, 130 may be attached to the substrate 110 by identical joints or by different types of joints. Furthermore, the first and/or the second semiconductor die 120, 130 may be electrically coupled to the substrate 110. In particular, a power electrode on the lower side of the first and/or the second semiconductor die 120, 130, wherein the lower side faces the substrate 110, may be electrically coupled to the substrate 110 via a solder joint or a sinter joint or a glued joint comprising electrically conductive glue.

The molded body 140 encapsulates the first and second semiconductor dies 120, 130. The molded body 140 may comprise or consist of any suitable mold material, for example an epoxy resin. According to an example, the molded body 140 also comprises filler particles, for example anorganic filler particles configured to reduce the thermal resistance of the molded body 140. The molded body 140 may be fabricated by any suitable molding process, e.g. compression molding, transfer molding or injection molding.

The molded body 140 comprises a first external side 141 facing away from the substrate 110. The molded body 140 may also comprise a second external side 142 opposite the first external side 141. Furthermore, the molded body 140 may comprise lateral external sides 143 connecting the first and second external sides 141, 142.

According to an example, the substrate 110 is at least partially exposed from the molded body 140 at the second external side 142. According to an example, external contacts of the semiconductor package 100 are exposed from at least one of the lateral external sides 143 of the molded body 140. For example, external contacts may be exposed from two opposite lateral external sides 143 or from all four lateral external sides 143. However, it is also possible that external contacts are exposed from the first external side 141 and/or the second external side 142 of the molded body 140.

The molded body 140 may have any suitable shape and any suitable dimensions. For example, the molded body 140 may have a quadratic or a rectangular shape as seen from above the first external side 141 (compare Fig. 1A). The molded body 140 may for example have a length or width measured between two opposite lateral external sides 143 of about 10cm or less, or about 5cm or less, or about 3cm or less, or about 2cm or less, or about 1cm or less. The molded body 140 may for example have a thickness measured between the first and second external sides 141, 142 of about 5cm or less, or about 3cm or less, or about 2cm or less, or about 1cm or less, or about 0.5cm or less.

The electrical connectors 150 extend at least partially through the molded body 140 from the first external side 141 to the first semiconductor die 120 and/or to the second semiconductor die 130. The electrical connectors 150 may comprise or consist of any suitable metal or metal alloy. The electrical connectors 150 may for example comprise or consist of Ag, Al, Au or Cu.

At least one or some or all of the electrical connectors 150 may for example comprise or consist of vias (in other words, the respective electrical connector 150 may comprise or consist of a material that is deposited using a suitable plating technique). However, it is also possible that at least one or some or all of the vias comprise or consist of bond wires and/or ribbons and/or wire loops and/or electrically conductive spacers (in other words, the respective electrical connector 150 may comprise or consist of a metal piece that is deposited all at once).

According to an example, one or more of the electrical connectors 150 extend at least partially through the molded body 140 from the first external side 141 to the substrate 110 (compare Fig. 1B).

The plurality of plated conductive tracks 160 is arranged in trenches 170 within the molded body 140. The trenches 170 are in particular arranged on the first external side 141 of the molded body 140. The conductive tracks 160 may be arranged in the trenches 170 such that an upper surface of the conductive tracks 160 is coplanar with the first external side 141 or such that the upper surface is arranged below the plane comprising the first external side 141 (compare Fig. 1C).

The conductive tracks 160 may comprise or consist of any suitable metal or metal alloy. The conductive tracks 160 may e.g. comprise or consist of Ag, Al, Au or Cu. The conductive tracks 160 and the electrical connectors 150 may comprise or consist of the same metal or metal alloy. The conductive tracks 160 and the electrical connectors 150 may for example be fabricated in the same plating process.

The conductive tracks 160 may have any suitable shape and any suitable dimensions. The conductive tracks 160 may for example have an essentially quadratic or rectangular or trapezoidal cross section. The conductive tracks 160 may for example have a width and/or a thickness of about 5mm or less, or 3mm or less, or 1mm or less, or 0.5mm or less, or 200µm or less, or 100µm or less, or 30µm or less. Adjacent ones of the conductive tracks 160 may for example be arranged with a pitch of 500µm or less, or 200µm or less, or 100µm or less, or 70µm or less.

As shown in Figs. 1A-1C, the conductive tracks 160 may be arranged on the first external side 141 of the molded body 140 such that the conductive tracks 160 are exposed from the molded body 140. The conductive tracks 160 may be arranged directly on the mold material of the molded body 140, without any intervening layer.

The plurality of conductive tracks 160 may constitute a redistribution layer (RDL) of the semiconductor package 100, wherein the redistribution layer is formed within the molded body 140. The conductive tracks 160 may be solely arranged on the first external side 141, as shown in the example of Figs. 1A-1C. However, it is also possible that conductive tracks 160 are (also) arranged on the second external side 142.

One or more of the conductive tracks 160 are coupled to the first semiconductor die 120 and/or to the second semiconductor die 130 by the electrical connectors 150. One or more of the conductive tracks 160 may be coupled to the substrate 110 by the electrical connectors 150. The conductive tracks 160 and electrical connectors 150 may be configured to electrically couple the semiconductor dies 120, 130 to each other and/or to the substrate 110, in particular to external contacts of the substrate 110.

The semiconductor package 100 may for example combine advantages of a leadframe based package (e.g. comprising a leadframe with high current capability, low cost of encapsulation) with advantages of chip embedding technology (RDL with fine pitch and high interconnect density instead of bond wire connections).

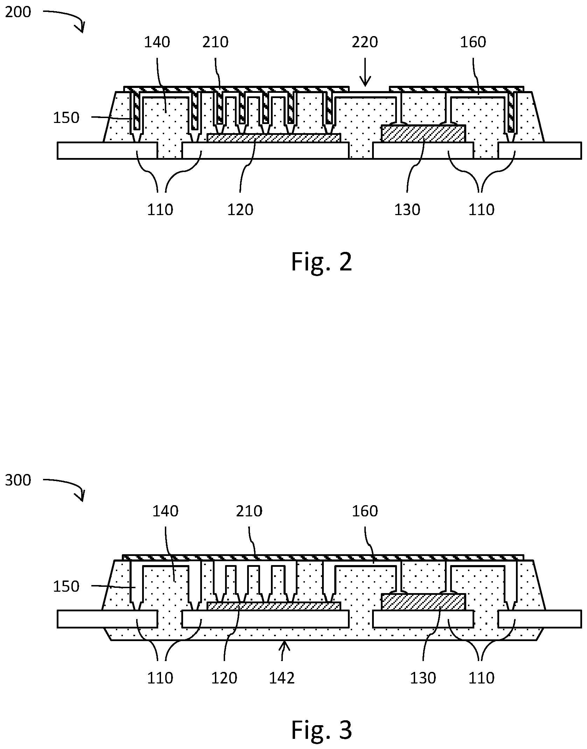

Figure 2 shows a sectional view of a further semiconductor package 200 which may be similar or identical to the semiconductor package 100, except for the differences described in the following.

In particular, the semiconductor package 200 comprises a dielectric layer 210 at least partially covering the conductive tracks 160. According to an example, the dielectric layer 210 comprises or consists of solder resist. According to another example, the dielectric layer 210 comprises mold material. The dielectric layer 210 may be configured as a protective layer protecting the conductive tracks 160 from the environment.

The dielectric layer 210 may partially or completely cover the first external side 141 of the molded body 140. According to an example, a further dielectric layer may be arranged on the second external side 142 of the molded body 140 and may for example at least partially cover the substrate 110 and/or further conductive tracks arranged on the second external side 142.

As shown in Fig. 2, the dielectric layer 210 may extend into at least some of the electrical connectors 150. In other words, the electrical connectors 150 may comprise an outer wall consisting of a metal or metal alloy and an inner core consisting of dielectric material.

The conductive tracks 160 may be partially exposed from the dielectric layer 210 such that the exposed part constitutes an external contact pad 220 of the semiconductor package 200. The semiconductor package 200 may comprise more than one external contact pad 220.

The external contact pad(s) 220 may for example be configured for being coupled to a passive electrical device like a capacitor or an inductor or the external contact pad(s) 220 may be configured for being coupled to an active electrical device like a semiconductor die or another semiconductor package.

Figure 3 shows a sectional view of a further semiconductor package 300 which may be similar or identical to the semiconductor package 100 or 200, except for the differences described in the following.

In the semiconductor package 300, the second external side 142 of the molded body 140 is not coplanar with the lower side of the substrate 110. Instead, the molded body 140 at least partially covers the lower side of the substrate 110.

A thickness of the molded body 140 below the lower side of the substrate 110 may for example be 3mm or less, or 1mm or less, or 0.5mm or less, or 0.1mm or less. A thickness of the molded body 140 above the upper side of the substrate 110 may for example be 10mm or less, or 5mm or less, or 3mm or less, or 1mm or less, or 0.5mm or less. A thickness of the molded body 140 above the upper side of the first and second semiconductor dies 120, 130 may for example be 3mm or less, or 1mm or less, or 0.5mm or less, or 0.1mm or less. A thickness of the dielectric layer 210 may for example be about 1mm or less, or 0.5mm or less, or 0.3mm or less, or 0.15mm or less.

The thickness of the molded body 140 above the first and second semiconductor dies 120, 130 may be lower in the case that the electrical connectors 150 comprise a plated material than in the case that the electrical connectors 150 comprise bond wires. Bond wires form a loop between their attachment points which requires a certain minimum height. This in turn sets a lower limit for the thickness of the molded body 140.

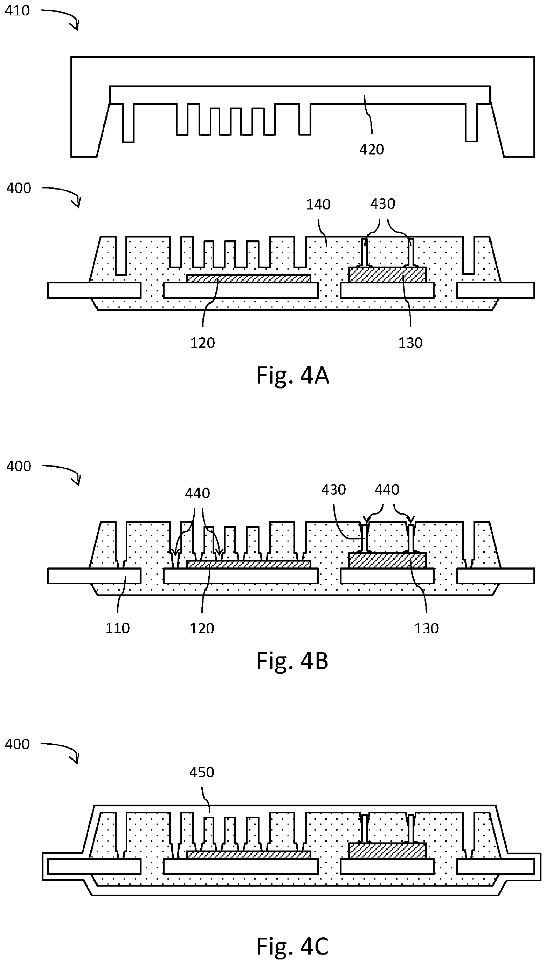

Figures 4A to 4C show a semiconductor package 400 in various stages of fabrication, according to an exemplary method for fabricating semiconductor packages. The semiconductor package 400 may be similar or identical to the semiconductor package 100, 200 or 300.

Figure 4A shows an upper part of a mold tool 410 as well as the semiconductor package 400 in a stage of fabrication after the molding process. The mold tool 410 comprises a structured inner surface such that during the molding process, holes for the electrical connectors 150 and/or the trenches 170 for the conductive tracks 160 are formed in the molded body 140 by the mold tool 410.

According to an example, the structured inner surface of the mold tool 410 is provided by an insert 420 inserted into the mold tool 410. The mold tool 410 may be equipped with different inserts 420, depending on the desired structure.

According to an example, the semiconductor package 400 may comprise one or more bond wire stubs 430 at least partially covered by the molded body 140. The bond wire stubs 430 may be coupled to the first semiconductor die 120 and/or to the second semiconductor die 130. The bond wire stubs 430 may be configured as electrical connectors 150.

Figure 4B shows the semiconductor package 400 after a drilling process has been performed on the molded body 140 to fabricate drill holes 440. The drilling process may be used to expose the substrate 110 and/or the first semiconductor die 120 and/or the second semiconductor die 130 and/or the bond wire stubs 430 from the molded body 140 at the drill holes 440.

The drilling process may for example comprise laser drilling and/or mechanical drilling. By fabricating the molded body 140 such that holes and/or trenches are already generated during the molding process, the amount of material which has to be removed in the drilling process can be reduced. However, it is also possible that no such holes and/or no such trenches are generated during the molding process. In this case, openings in the molded body 140 for the electrical connectors 150 and/or the trenches 170 for the conductive tracks 160 are only provided by the drilling process.

By providing the bond wire stubs 430, it is not necessary to drill down to the upper surface of the first semiconductor die 120 and/or the second semiconductor die 130. In this way, damaging the semiconductor dies 120, 130 in the drilling process may be avoided.

Figure 4C shows the semiconductor package 400 after a plating process has been performed to deposit a plating layer 450 on the molded body 140. The plating process may for example comprise heating up the outer surface of the molded body 140 and then depositing a layer of conductive polymer or Pd on the molded body 140. The plating process may for example comprise providing a laser-activatable compound. The plating process may further comprise a subsequent electroplating step.

The plating process may be used to fabricate the conductive tracks 160 and/or the electrical connectors 150. To this end, fabricating the semiconductor package 400 may further comprise structuring the plating layer 450, for example using a photolithography process. Furthermore, fabricating the semiconductor package 400 may comprise depositing the dielectric layer 210 on the conductive tracks 160 and the molded body 140 and possibly structuring the dielectric layer 210 to provide the conductive pad 220.

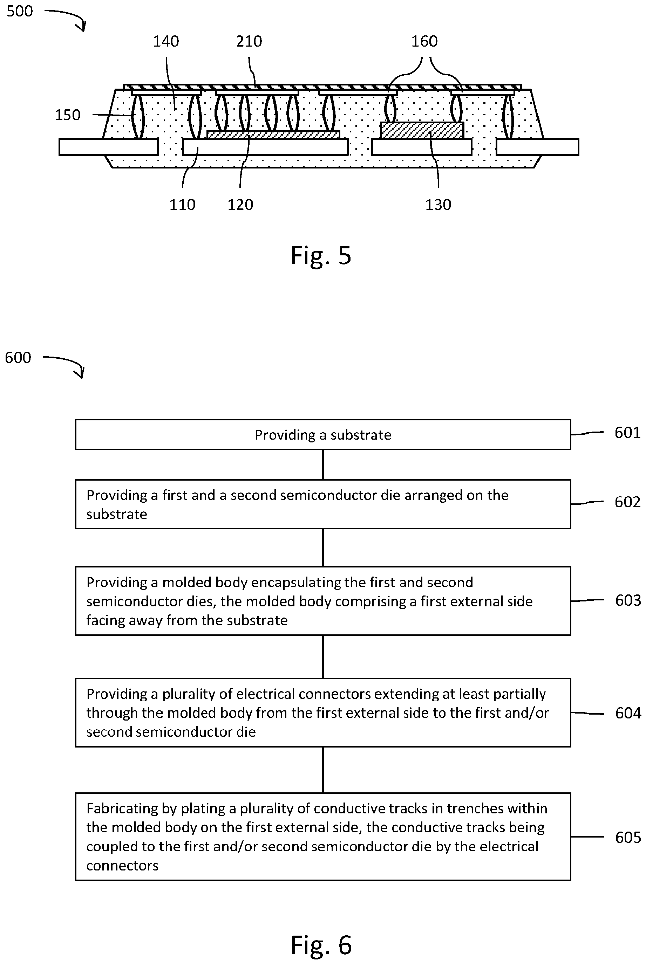

Figure 5 shows a further semiconductor package 500 which may be similar or identical to the semiconductor package 100, 200, 300 or 400, except for the differences described in the following.

In the semiconductor package 500, at least some of the electrical connectors 150 comprise or consist of bond wire loops. The two ends of such a bond wire loop are not coupled to two different contacts but instead both ends are coupled to the same contact, e.g. to the same electrode of the first semiconductor die 120 or the second semiconductor die 130. However, the upper part of these bond wire loops is coupled to the conductive tracks 160. In this manner, the bond wire loops may serve as solely vertical electrical connectors 150 in the semiconductor package 500.

Fabricating the semiconductor package 500 may comprise providing the bond wire loops, molding to provide the molded body 140, exposing the upper part of the bond wire loops from the molded body (e.g. via grinding or drilling) and plating to provide the conductive tracks 160.

According to an example, the semiconductor package 500 may also comprise one or more plated electrical connectors 150. According to an example, the semiconductor package 500 may also comprise one or more bond wires, wherein the ends of the bond wire are coupled to different contacts. According to an example, bond wire stubs instead of bond wire loops may be used (in a bond wire stub, one end of the bond wire is coupled to a contact and the stub is then clipped off). According to an example, ribbon loops instead of or in addition to bond wire loops may be used.

Figure 6 is a flow chart of a method 600 for fabricating a semiconductor package. The method 600 may for example be used to fabricate the semiconductor packages 100 to 500.

The method 600 comprises at 601 an act of providing a substrate, at 602 an act of providing a first and a second semiconductor die arranged on the substrate, at 603 an act of providing a molded body encapsulating the first and second semiconductor dies, the molded body comprising a first external side facing away from the substrate, at 604 an act of providing a plurality of electrical connectors extending at least partially through the molded body from the first external side to the first and/or second semiconductor die, and at 605 an act of fabricating by plating a plurality of conductive tracks in trenches within the molded body on the first external side, the conductive tracks being coupled to the first and/or second semiconductor die by the electrical connectors.

### EXAMPLES

In the following, the semiconductor package and the method for fabricating a semiconductor package are further explained using specific examples.

Example 1 is a semiconductor package, comprising: a substrate, a first and a second semiconductor die arranged on the substrate, a molded body encapsulating the first and second semiconductor dies, the molded body comprising a first external side facing away from the substrate, a plurality of electrical connectors extending at least partially through the molded body from the first external side to the first and/or second semiconductor die, and a plurality of plated conductive tracks arranged in trenches within the molded body on the first external side, the conductive tracks being coupled to the first and/or second semiconductor die by the electrical connectors.

Example 2 is the semiconductor package of example 1, further comprising: a solder resist layer at least partially covering the conductive tracks.

Example 3 is the semiconductor package of example 2, wherein part of the conductive tracks is exposed from the solder resist layer to provide one or more external contact pads.

Example 4 is the semiconductor package of one of the preceding examples, wherein the substrate comprises a first part and a second part, the first and second parts being spaced apart from one another, and wherein the first semiconductor die is arranged on the first part and the second semiconductor die is arranged on the second part.

Example 5 is the semiconductor package of one of the preceding examples, wherein the substrate comprises a substrate of the type leadframe, direct copper bonded, direct aluminum bond, active metal brazed, and/or printed circuit board.

Example 6 is the semiconductor package of one of the preceding examples, wherein the electrical connectors comprise at least one bond wire loop or at least one ribbon loop.

Example 7 is the semiconductor package of one of the preceding examples, wherein adjacent one of the conductive tracks are arranged at a pitch of 100µm or less, in particular 70µm or less.

Example 8 is a method for fabricating a semiconductor package, the method comprising: providing a substrate, providing a first and a second semiconductor die arranged on the substrate, providing a molded body encapsulating the first and second semiconductor dies, the molded body comprising a first external side facing away from the substrate, providing a plurality of electrical connectors extending at least partially through the molded body from the first external side to the first and/or second semiconductor die, and fabricating by plating a plurality of conductive tracks in trenches within the molded body on the first external side, the conductive tracks being coupled to the first and/or second semiconductor die by the electrical connectors.

Example 9 is the method of example 8, wherein providing the molded body comprises using a structured mold tool to fabricate by molding the molded body comprising the trenches.

Example 10 is the method of example 8 or 9, wherein providing the plurality of electrical connectors comprises: drilling at least partially through the encapsulation body and subsequently performing a plating process to form vias, and/or arranging bond wire loops and/or ribbon loops on the substrate and/or on at least one of the first and second semiconductor dies.

Example 11 is the method of example 10, wherein a structured mold tool is used to fabricate holes in the molded body, and wherein the drilling is performed within the holes to expose an upper side of the substrate, an upper side of the first and/or second semiconductor die, and/or a wire bond stump coupled to the upper side of the first and/or second semiconductor die.

Example 12 is the method of one of examples 8 to 11, wherein fabricating the plurality of conductive tracks comprises electroplating over the whole exterior of the molded body to form a plated layer and subsequently structuring the plated layer.

Example 13 is the method of one of examples 8 to 12, further comprising: at least partially covering the conductive tracks with a solder resist layer.

Example 14 is the method of one of examples 8 to 13, further comprising: after fabricating the conductive tracks, singulating the semiconductor package.

Example 15 is the method of example 14, wherein singulating comprises cutting through a leadframe assembly.

Example 16 is an apparatus comprising means for performing the method according to anyone of examples 8 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A semiconductor package (100), comprising:
a substrate (110),
a first and a second semiconductor die (120, 130) arranged on the substrate (110),
a molded body (140) encapsulating the first and second semiconductor dies (120, 130), the molded body (140) comprising a first external side (141) facing away from the substrate (110),
a plurality of electrical connectors (150) extending at least partially through the molded body (140) from the first external side (141) to the first and/or second semiconductor die (120, 130), and
a plurality of plated conductive tracks (160) arranged in trenches (170) within the molded body (140) on the first external side (141), the conductive tracks (160) being coupled to the first and/or second semiconductor die (120, 130) by the electrical connectors (150).

2. The semiconductor package (200, 300, 500) of claim 1, further comprising:
a solder resist layer (210) at least partially covering the conductive tracks (160).

3. The semiconductor package of claim 2 (200), wherein part of the conductive tracks (160) is exposed from the solder resist layer (210) to provide one or more external contact pads (220) .

4. The semiconductor package (100) of one of the preceding claims, wherein the substrate (110) comprises a first part (110_1) and a second part (110_2), the first and second parts (110_1, 110_2) being spaced apart from one another, and
wherein the first semiconductor die (120) is arranged on the first part (110_1) and the second semiconductor die (130) is arranged on the second part (110_2).

5. The semiconductor package (100) of one of the preceding claims, wherein the substrate (110) comprises a substrate of the type leadframe, direct copper bonded, direct aluminum bond, active metal brazed, and/or printed circuit board.

6. The semiconductor package (500) of one of the preceding claims, wherein the electrical connectors (150) comprise at least one bond wire loop or at least one ribbon loop.

7. The semiconductor package (100) of one of the preceding claims, wherein adjacent ones of the conductive tracks (160) are arranged at a pitch of 100µm or less, in particular 70µm or less.

8. A method (600) for fabricating a semiconductor package, the method comprising:
providing (601) a substrate,
providing (602) a first and a second semiconductor die arranged on the substrate,
providing (603) a molded body encapsulating the first and second semiconductor dies, the molded body comprising a first external side facing away from the substrate,
providing (604) a plurality of electrical connectors extending at least partially through the molded body from the first external side to the first and/or second semiconductor die, and
fabricating (605) by plating a plurality of conductive tracks in trenches within the molded body on the first external side, the conductive tracks being coupled to the first and/or second semiconductor die by the electrical connectors.

9. The method (600) of claim 8, wherein providing (603) the molded body comprises using a structured mold tool to fabricate by molding the molded body comprising the trenches.

10. The method (600) of claim 8 or 9, wherein providing (604) the plurality of electrical connectors comprises:
drilling at least partially through the encapsulation body and subsequently performing a plating process to form vias, and/or
arranging bond wire loops and/or ribbon loops on the substrate and/or on at least one of the first and second semiconductor dies.

11. The method (600) of claim 10, wherein a structured mold tool is used to fabricate holes in the molded body, and
wherein the drilling is performed within the holes to expose an upper side of the substrate, an upper side of the first and/or second semiconductor die, and/or a wire bond stump coupled to the upper side of the first and/or second semiconductor die.

12. The method (600) of one of claims 8 to 11, wherein fabricating (605) the plurality of conductive tracks comprises electroplating over the whole exterior of the molded body to form a plated layer and subsequently structuring the plated layer.

13. The method (600) of one of claims 8 to 12, further comprising:
at least partially covering the conductive tracks with a solder resist layer.

14. The method (600) of one of claims 8 to 13, further comprising:
after fabricating (605) the conductive tracks, singulating the semiconductor package.

15. The method (600) of claim 14, wherein singulating comprises cutting through a leadframe assembly.
